Europäisches Patentamt

European Patent Office

Office européen des brevets

(11) Veröffentlichungsnummer: **0 321 808**
**A1**

# EUROPÄISCHE PATENTANMELDUNG

(21) Anmeldenummer: **88120666.8**

(22) Anmeldetag: **10.12.88**

(51) Int. Cl.⁴: **G01R 27/32**

(30) Priorität: **23.12.87 CH 5013/87**

(43) Veröffentlichungstag der Anmeldung:
**28.06.89 Patentblatt 89/26**

(84) Benannte Vertragsstaaten:
**CH DE GB LI SE**

(71) Anmelder: **BBC Brown Boveri
Aktiengesellschaft**

**CH-5401 Baden(CH)**

(72) Erfinder: **Garbe, Heyno, Dr.
Im Rüteli 11
CH-5404 Baden(CH)**
Erfinder: **Hansen, Diethard, Dr.
Bahnhofstrasse 39a
CH-8965 Berikon(CH)**

(54) **Verfahren zum Messen eines Wellenwiderstandes und einer Ausbreitungskonstante eines Zweitors.**

(57) Bei einem Verfahren zum Messen eines Wellenwiderstandes und einer Ausbreitungskonstante eines Zweitors (2) wird ein Ausgangstor (5) des Zweitors (2) nacheinander mit mindestens zwei verschiedenen, vom Zweitor (2) unabhängigen, endlichen bekannten Restimpedanzen (3a, 3b) abgeschlossen. Für jede Restimpedanz (3a, 3b) wird eine Eingangsimpedanz (ZE1, ZE2) gemessen. Aus den effektiven Restimpedanzen (ZA1, ZA2) der Restimpedanzen (3a, 3b) und den entsprechenden Eingangsimpedanzen (ZE1, ZE2) werden die Ausbreitungskonstante und der Wellenwiderstand ermittelt.

Fig.1

EP 0 321 808 A1

# VERFAHREN ZUM MESSEN EINES WELLENWIDERSTANDES UND EINER AUSBREITUNGSKONSTANTE EINES ZWEITORS

## TECHNISCHES GEBIET

Die Erfindung betrifft ein Verfahren zum Messen eines Wellenwiderstandes und einer Ausbreitungskonstante eines Zweitors, wobei an einem Eingangstor des Zweitors bei mindestens zwei verschiedenen, gegebenen Abschlüssen eines Ausgangstors des Zweitors mit einem Reflexionsmessgerät minestens zwei Eingangsimpedanzen gemessen werden und aus den mindestens zwei Eingangsimpedanzen ein Wellenwiderstand und eine Ausbreitungskonstante ermittelt werden.

## STAND DER TECHNIK

Bei der Uebertragung von hochfrequenten Signalen ist es unabdingbar, die Eigenschaften der Uebertragungsstrecke genau zu kennen, um Endgeräte (z.B. Sender und Empfänger) und Uebertragungsstrecke aufeinander abstimmen zu können. Nur so kann eine zuverlässige Signalübertragung gewährleistet werden.

Die Eigenschaften eines linearen Zweitors sind bekanntlich im wesentlichen gegeben durch die beiden Grössen Wellenwiderstand und Ausbreitungskonstante. Diese Grössen lassen sich z.B. mit Hilfe einer Reflexionsmessung bestimmen. Ein entsprechendes Verfahren wird z.B. in der Druckschrift "Durchgangsdämpfung - ermittelt über Reflexionsmessung", Neues von Rohde + Schwarz 118 Sommer 1987, offenbart. Eine Signalwelle wird dabei über ein Eingangstor in das zu messende Zweitor eingekoppelt, durchläuft das Zweitor, wird an einem Ausgangstor totalreflektiert und läuft wieder zum Eingangstor des Zweitors zurück, wo sie dann gemessen wird. Auf diese Weise werden zwei Eingangsimpedanzen gemessen, wobei die Totalreflexion am Ausgangstor einmal durch einen Kurzschluss und einmal durch einen Leerlauf bewirkt wird.

Der Vorteil der Reflexionsmessung liegt darin, dass die Signalwelle am selben Ort gemessen wird, wo sie erzeugt wird. Da ausserdem nur ein Eingangstor des Zweitors an das Messgerät angeschlossen werden muss, können z.B. auch verlegte Kabel problemlos ausgemessen werden.

Beim bekannten Messverfahren treten allerdings Probleme auf, wenn in einem Frequenzbereich von 100 MHz und mehr gearbeitet werden soll. Es erweist sich nämlich als schwierig, bei solchen Frequenzen gute Kurzschlüsse respektive Leerläufe zu realisieren. Als Folge davon wird die Totalreflexion gestört und die Messergebnisse werden sehr ungenau.

## DARSTELLUNG DER ERFINDUNG

Aufgabe der vorliegenden Erfindung ist es, ein Verfahren zum Messen eines Wellenwiderstandes und einer Ausbreitungskonstante eines Zweitors, wobei an einem Eingangstor des Zweitors bei mindestens zwei verschiedenen, gegebenen Abschlüssen eines Ausgangstors des Zweitors mit einem Reflexionsmessgerät mindestens zwei Eingangsimpedanzen gemessen werden und aus dem mindestens zwei Eingangsimpedanzen ein Wellenwiderstand und eine Ausbreitungskonstante ermittelt werden, zu schaffen, welches auch bei hohen Messfrequenzen, insbesondere bei 100 MHz und mehr, mit grosser Genauigkeit arbeitet.

Erfindungsgemäss besteht die Lösung darin, dass die mindestens zwei Abschlüsse bekannte, vom Zweitor unabhängige, endliche Restimpedanzen sind.

Der Kern der Erfindung ist darin zu sehen, dass die schwer zu realisierende Totalreflexion durch eine Teilreflexion bekannten Ausmasses ersetzt wird. Kurzschluss und Leerlauf werden ersetzt durch Restimpedanzen, welche klar grösser als Null und kleiner als Unendlich sind. Die Restimpedanzen sind grundsätzlich unabhängig vom Zweitor, d.h. dass sie im allgemeinen Fall nicht angepasst sind.

Ein weiterer Vorteil der Erfindung ist darin zu sehen, dass sich die Messignale durch eine geeignete Wahl der Restimpedanzen ohne zusätzlichen Aufwand auf einen für ein verwendetes Messgerät geeigneten Messbereich einschränken lässt.

Bevorzugte Ausführungsformen der Erfindung ergeben sich aus den Unteransprüchen.

## KURZE BESCHREIBUNG DER ZEICHNUNG

Nachfolgend soll die Erfindung anhand von Ausführungsbeispielen und im Zusammenhang mit der Zeichnung näher erläutert werden. Es zeigen:

Fig. 1 eine Anordnung zum Messen eines Wellenwiderstandes und einer Ausbreitungskonstante eines Zweitors;

Fig. 2 A und B Schritte eines Verfahrens zum Messen eines Wellenwiderstandes und einer Ausbreitungskonstante einer Leitung und

Fig. 3 A und B Schritte eines Verfahrens zum Messen eines Wellenwiderstandes und einer Ausbreitungskonstante eines Absorbermediums.

## WEGE ZUR AUSFÜHRUNG DER ERFINDUNG

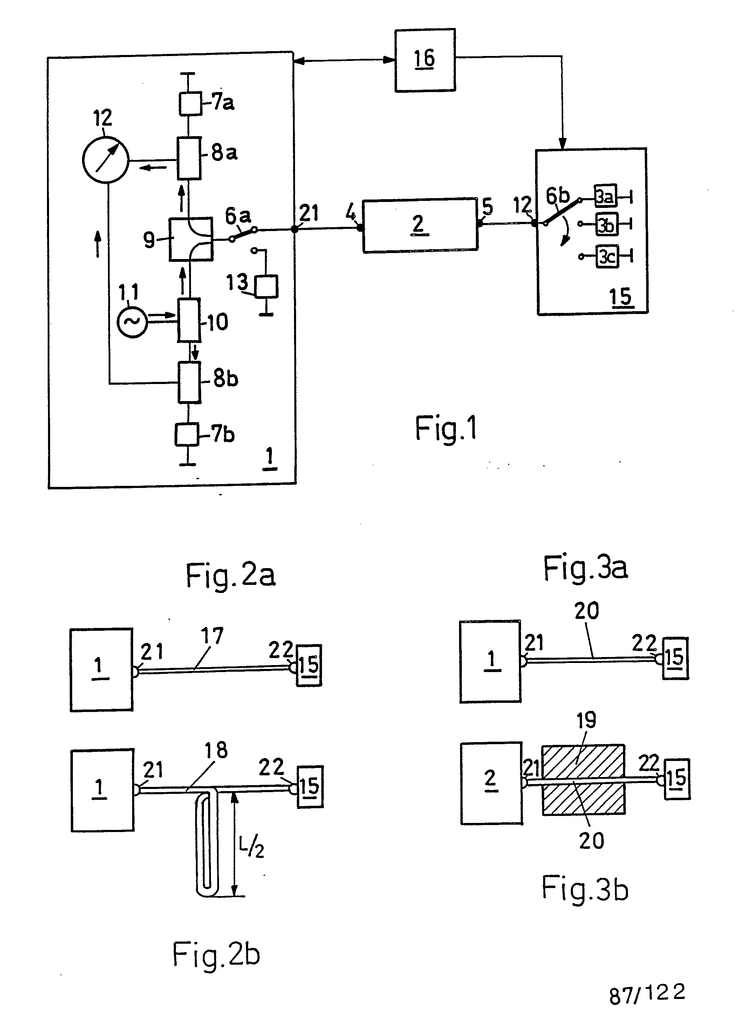

Fig. 1 zeigt eine Anordnung zum Ausführung des erfindungsgemässen Verfahrens. Sie umfasst ein Reflexionsmessgerät 1, eine Restimpedanzwahlschaltung 15 und eine Rechenschaltung 16.

Das Reflexionsmessgerät 1 ist als solches z.B. aus der eingangsgenannten Druckschrift von Rohde + Schwarz bekannt. Ein Signalgenerator 11 erzeugt eine Signalwelle einer bekannten Frequenz. Diese Signalwelle gelangt einerseits als Messwelle über einen Einkoppler 10 und eine Reflexionsfaktorbrücke 9 zu einem Schalter 6a und andererseits als Referenzwelle über ein Messadapter 8b zu einem Vektorvoltmeter 12. Ein bei einer Messung reflektierter Teil der Messwelle läuft über die Reflexionsfaktorbrücke 9 und ein Messadapter 8a zum Vektorvoltmeter 12.

Zwischen der Reflexionsfaktorbrücke 9 und einem Ausgang 21 des Reflexionsmessgerätes 1 ist der Schalter 6a angeordnet. Er verbindet die Reflextionsfaktorbrücke 9 entweder mit dem Ausgang 21 oder mit einem Eichabschluss 13.

Die beiden Messadapter 8a und 8b sind auf einer Seite jeweils mit einem Wellenleiterabschluss 7a resp. 7b, welche z.B. als 50 Ohm-Widerstände aufgeführt sein können, abgeschlossen.

Die Restimpedanzwahlschaltung 15 umfasst z.B. 3 Restimpedanzen 3a, 3b, 3c und einen Schalter 6b. Mit dem Schalter 6b lässt sich ein Eingang 22 der Restimpedanzwahlschaltung 15 wahlweise mit einem der 3 Restimpedanzen 3a, 3b, 3c verbinden.

Die Rechenschaltung 16, welche in diesem Ausführungsbeispiel vorgesehen ist, steuert auf der einen Seite den Schalter 6b der Restimpedanzwahlschaltung 15 und auf der anderen Seite das Reflexionsmessgerät 1. Sie regelt den Betriebszustand, speichert vom Vektorvoltmeter 12 gemessene Eingangsimpedanzen und ermittelt aus diesen den Wellenwiderstand und die Ausbreitungskonstante.

Ein zu messendes Zweitor 2 wird mit einem Eingangstor 4 an den Ausgang 21 des Reflexionsmessgeräts 1 und mit einem Ausgangstor 5 an den Eingang 22 der Restimpedanzwahlschaltung 15 angeschlossen.

Das Kennzeichen der Erfindung verkörpert sich in den Restimpedanzen 3a, 3b, 3c, welche den Abschluss des Ausgangstors 5 bilden. Diese sind nicht mehr wie bisher Null (Kurzschluss) und Unendlich (Leerlauf), sondern bekannte, vom Zweitor 2 unabhängige und endliche Impedanzen. Im beschriebenen Ausführungsbeispiel haben die Restimpedanzen 3a, 3b, 3c Widerstandswerte von 27 Ohm, 50 Ohm, 68 Ohm respektive. Selbstverständlich können die Widerstandswerte weitgehend beliebig angesetzt werden. Es ist aber sicher von Vorteil, wenn sie nicht allzu eng beieinanderliegen.

Das erfindungsgemässe Verfahren läuft bei der in Fig. 1 gezeigten Anordnung in 6 Schritten ab.

Als erstes wird das Reflexionsmessgerät 1, genauer gesagt das Vektorvoltmeter 12 geeicht. Zu diesem Zweck wird der Schalter 6a in eine Stellung gebracht, in welcher er die Reflexionsfaktorbrücke 9 mit dem Eichabschluss 13 verbindet. Die Messwelle des Signalgenerators 11 läuft dann über den Einkoppler 10 und die Reflexionsfaktorbrücke 9 zum Eichabschluss 13; wird dort totalreflektiert und gelangt über die Reflexionsfaktorbrücke 9 und den Messadapter 8a zum Vektorvoltmeter 12.

Ein auf diese Weise gemessener Impedanzwert wird den folgenden Impedanzwerten als Nullniveau zugrundegelegt.

Als zweites werden gemäss einer bevorzugten Ausführungsform der Erfindung die Restimpedanzen 3a, 3b, 3c einzeln ausgemessen.

An den Ausgang 21 des Reflexionsmessgeräts 1 wird direkt der Eingang 22 der Restimpedanzwahlschaltung 15 angehängt. (Der Schalter 6a ist jetzt in der Stellung, in welcher er die Reflexionsfaktorbrücke 9 mit dem Ausgang 21 des Reflexionsmessgeräts 1 verbindet.) Nacheinander werden alle vorhandenen Restimpedanzen 3a, 3b, 3c mit dem Schalter 6b angewählt, und für jede wird eine effektive Restimpedanz ZA1, ZA2, ZA3 gemessen. Die Rechenschaltung 16 speichert die vom Vektorvoltmeter 12 gelieferten effektiven Restimpedanzen ZA1, ZA2, ZA3 ab.

Als drittes wird das Zweitor 2 mit einem Eingang 4 an den Ausgang 21 des Reflexionsmessgeräts 1 und mit einem Ausgangstor 5 an den Eingang 22 der Restimpedanzwahlschaltung 15 angeschlossen.

Als viertes werden drei Eingangsimpedanzen ZE1, ZE2, ZE3 des Zweitors 2 gemessen. Und zwar entspricht jeder Stellung des Schalters 6b ein gegebener, bekannter Abschluss des Ausgangstors 5 des Zweitors 2. Die 3 Eingangsimpedanzen ZE1, ZE2, ZE3 werden wiederum vom Vektorvoltmeter 12 an die Rechenschaltung 16 weitergegeben und dort gespeichert.

Als fünftes wird aus den Eingangsimpedanzen ZE1, ZE2, ZE3 (und den bekannten effektiven Restimpedanzen ZA1, ZA2, ZA3) der Wellenwiderstand des Zweitors 2 ermittelt. Dies geschieht in der Rechenschaltung 16.

Um den Wellenwiderstand bestimmen zu können, müssen mindestens zwei Wertepaare ZE1/ZA1, ZE2/ZA2 (d.h. mindestens zwei Eingangsimpedanzen ZE1, ZE2 mit den entsprechenden effektiven Restimpedanzen ZA1, ZA2) zur Verfügung stehen. Sind mehr als zwei vorhanden, so werden daraus eine Mehrzahl von vorläufigen Wellenwiderständen ZW1, ZW2 berechnet und aus diesen durch eine Mittelung ein endgültiger Wellenwiderstand ZW ermittelt, welcher mit einem geringeren Messfehler behaftet ist als die vorläufigen Wellenwiderstände ZW1, ZW2.

Gemäss einer bevorzugten Ausführungsform der Erfindung liegen drei Wertepaare ZE1/ZA1, ZE2/ZA2, ZE3/ZA3 vor. Aus je zwei davon wird jeweils ein entsprechender vorläufiger Wellenwiderstand ZW1, ZW2, ZW3 berechnet. Anhand des ersten vorläufigen Wellenwiderstandes ZW1 sei gezeigt, wie im allgemeinen Fall aus zwei Wertepaaren ZE1/ZA1, ZE2/ZA2 erfindungemäss der Wellenwiderstand berechnet wird. Und zwar benützt man eine Beziehung von der Art

$$ZW1 = \sqrt{\frac{ZA1 \cdot ZE1 \cdot (ZA2 - ZE2) - ZA2 \cdot ZE2 \cdot (ZA1 - ZE1)}{(ZA2 - ZE2) - (ZA1 - ZE1)}} \qquad (I)$$

wobei

$$\left. \begin{array}{l} ZE1 = \\ ZE2 = \end{array} \right\} \text{Eingangsimpedanz für effektive Restimpedanz} \left\{ \begin{array}{l} ZA1 \\ ZA2 \end{array} \right.$$

Man beachte, dass im allgemeinen die Eingangsimpedanzen ZE1, ZE2 und die effektiven Restimpedanzen ZA1, ZA2, und damit auch der Wellenwiderstand ZW1 komplexwertig sind.

In analoger Weise werden die vorläufigen Wellenwiderstände ZW2 und ZW3 aus den verbleibenden Kombinationen von zwei Wertepaaren gebildet.

Der endgültige Wellenwiderstand ZW ergibt sich als Mittelwert aus den drei vorläufigen Wellenwiderständen ZW1, ZW2, ZW3.

Als sechstes wird schliesslich eine Ausbreitungskonstante g ermittelt. Auch sie lässt sich grundsätzlich aus zwei Wertepaaren ZE1/ZA1, ZE2/ZA2 berechnen. Analog zu oben können aber mehr als zwei Wertepaare dazu verwendet werden, mit Hilfe einer Mittelung den Messfehler der Ausbreitungskonstante g zu vermindern.

Für jedes der drei Wertepaare ZE1/ZA1, ZE2/ZA2, ZE3/ZA3 wird eine vorläufige Ausbreitungskonstante g1, g2, g3 berechnet. Anhand des ersten Wertepaares ZE1/ZA1 sei wiederum gezeigt wie im allgemeinen aus zwei Wertepaaren (oder aus einem Wellenwiderstand ZW1 und einem der zugrundegelegten zwei Wertepaaren ZE1/ZA1, ZE2/ZA2) erfindungsgemäss eine Ausbreitungskonstante berechnet wird. Man benutzt eine Beziehung von der Art

$$g1 = \frac{1}{2L} \ln \frac{(ZW1 + ZE1)(ZW1 - ZA1)}{(ZW1 - ZE1)(ZW1 + ZA1)} \qquad (II)$$

wobei

L = Länge

ln = natürlicher Logarithmus

ZW1 = Wellenwiderstand aus Formel (I)

Zur Länge L des Zweitors 2 ist folgendes anzumerken: Wenn das Zweitor 2 eine Leitung ist (z.B. ein Koaxialkabel), dann ist für die Länge L die Länge der gemessenen Leitung einzusetzen, so dass die Ausbreitungskonstante g1 eine Dämpfung und eine Phasendrehung pro Längeneinheit bezeichnet. Ist hingegen das Zweitor 2 nicht durch eine Länge charakterisierbar, so setzt man L = 1.

Im folgenden werden bevorzugte Ausführungsformen der Erfindung beschrieben, welche die Vielseitigkeit des erfindungsgemässen Verfahrens aufzeigen.

Als erstes soll ein Verfahren beschrieben werden, mit welchem sich der Wellenwiderstand und die Ausbreitungskonstante einer Leitung einfach und zugleich präzise bestimmen lässt.

Figuren 2A und B zeigen die wesentlichen Schritte zum Durchführen des entsprechenden Verfahrens. Ein Reflexionsmessgerät 1, eine Restimpedanzwahlschaltung 15 und eine in Figuren 2A und B nicht gezeigte Rechenschaltung 16 seien z.B. wie oben beschrieben ausgeführt. Eine kurze Leitung 17 wird mit gegebenen Anschlusssteckern einerseits an den Ausgang 21 des Reflexionsmessgerätes 1 und andererseits an den Eingang 22 der Restimpedanzwahlschaltung 15 angeschlossen. Die kurze Leitung 17 verkörpert aber nicht das in Fig. 1 gezeigte Zweitor 2. Vielmehr bildet sie zusammen mit den Restimpedanzen 3a, 3b, 3c jeweils eine tatsächliche Restimpedanz für noch zu beschreibende, nachfolgende Messungen.

Für jede der drei Restimpedanzen 3a, 3b, 3c wird eine effektive Restimpedanz ZA1, ZA2, ZA3 gemessen. Dann wird die kurze Leitung 17 durch eine lange Leitung 18 ersetzt. Es ist darauf zu achten, dass beide Leitungen mit identischen Anschlusssteckern versehen sind. Die lange Leitung 18 ist um eine Länge L länger als die kurze Leitung 17. Für jedes der Restimpedanzen 3a, 3b, 3c wird eine Eingangsimpedanz ZE1, ZE2, ZE3 der langen Leitung 18 gemessen. Aus den drei Wertepaaren ZE1/ZA1, ZE2/ZA2, ZE3/ZA3 wird auf die bereits beschriebene Weise ein Wellenwiderstand ZW und eine Ausbreitungskonstante g ermittelt.

Der springende Punkt bei der beschriebenen Ausführungsform der Erfindung ist die Tatsache, dass zuerst alle unerwünschten Einflüsse (Reflexion an Anschlusssteckern, Relais und Aehnlichem) eliminiert werden, indem eine Differenzmessung gemacht wird. Es ist wichtig, dass sich die kurze Leitung 17 von der langen Leitung 18 nur durch die Länge unterscheidet. In diesem Fall werden dann nur die Eigenschaften des zusätzlichen Stücks Leitung der Länge L gemessen. Dieses verkörpert in Tat und Wahrheit das Zweitor 2 von Fig. 1.

Das erfindungsgemässe Verfahren eignet sich auch, um Wellenwiderstand und Ausbreitungskonstante eines Dielektrikums z.B. eines Absorbermediums zu messen.

Fig. 3A und B zeigen die wesentlichen Schritte beim Durchführen eines erfindungsgemässen Verfahrens zum Messen von Wellenwiderstand und Ausbreitungskonstante eines Absorbermediums. Völlig analog zu Figuren 2A und B werden ein Reflexionsmessgerät 1, eine Restimpedanzwahlschaltung 15 und eine in Figuren 3A und B nicht gezeigte Rechenschaltung 16 eingesetzt. Der Ausgang 21 des Reflexionsmessgeräts 1 ist z.B. mit zwei parallelen Leitungsdrähten 20 mit dem Eingang 22 der Restimpedanzwahlschaltung 15 verbunden. Die parallelen Leitungsdrähte 20 sind von einem Dielektrikum z.B. Luft umgeben (Fig. 3A).

Für jede der drei Restimpedanzen 3a, 3b, 3c wird eine effektive Restimpedanz ZA1, ZA2, ZA3 gemessen. Dann werden die parallelen Leitungsdrähte 20 in ein Absorbermedium 19 gebracht (Fig. 3B). Nun werden drei Eingangsimpedanzen ZE1, ZE2, ZE3 gemessen. Der Wellenwiderstand und die Ausbreitungskonstante des Absorbermediums 19 ergeben sich wieder analog zum vorher beschriebenen Ausführungsbeispiel aus den drei Wertepaaren ZE1/ZA1, ZE2/ZA2, ZE3/ZA3.

Auch hier handelt es sich so zu sagen um eine Differenzmessung. Die Unterschiede zwischen effektiver Restimpedanz ZA1 und Eingangsimpedanz ZE1 sind allein darauf zurückzuführen, dass das Dielektrikum Luft gegen das Dielektrikum Absorbermedium ausgetauscht worden ist.

Die bisher beschriebenen Ausführungsbeispiele und Anordnungen zum Ausführen des erfindungsgemässen Verfahrens stellen zwar besonders günstige Ausführungsformen dar, beschränken die Erfindung jedoch in keiner Weise.

Eine Restimpedanzwahlschaltung 15 kann eine beliebige Zahl von Restimpedanzen 3a, 3b, ... umfassen. Es müssen jedoch mindestens zwei verschiedene, endliche Restimpedanzen 3a, 3b vorhanden sein. Entsprechend den Gesetzen der Statistik ist der Fehler des Wellenwiderstandes ZW und der Ausbreitungskonstante g je kleiner, auf je mehr Messungen sie gründen.

Eine Rechenschaltung 16 ist an und für sich nicht nötig. Sie erlaubt es jedoch das erfindungsgemässe Verfahren vollautomatisch auszuführen und trägt damit zum Bedienungskomfort der Anordnung bei. Wird auf die Rechenschaltung 16 verzichtet, so kann auch die Restimpedanzwahlschaltung 15 mit dem Schalter 6b durch Handmanipulation ersetzt werden. Man schliesst z.B. die verschiedenen Restimpedanzen 3a, 3b ... jedesmal von Hand an.

Selbstverständlich ist es nicht zwingend, sowohl Wellenwiderstand als auch Ausbreitungskonstante zu ermitteln. Auch wenn aber nur die Ausbreitungskonstante interessiert, ist es in der Praxis einfacher, zuerst einen Wellenwiderstand gemäss Formel (I) zu berechnen und diesen Wert dann in die Formel (II) einzusetzen. Abschliessend kann gesagt werden, dass mit der Erfindung ein Verfahren zur Verfügung steht, mit welchem sich Wellenwiderstand und Ausbreitungskonstante eines Zweitors mit grosser Genauigkeit bestimmen lassen.

**Ansprüche**

1. Verfahren zum Messen eines Wellenwiderstandes und einer Ausbreitungskonstante eines Zweitors, wobei

a) an einem Eingangstor (4) des Zweitors (2) bei mindestens zwei verschiedenen, gegebenen Abschlüssen eines Ausgangstors (5) des Zweitors (2) mit einem Reflexionsmessgerät (1) mindestens zwei Eingangsimpedanzen (ZE1, ZE2) gemessen werden und

b) aus den mindestens zwei Eingangsimpedanzen (ZE1, ZE2) ein Wellenwiderstand und eine Ausbreitungskonstante ermittelt werden,
dadurch gekennzeichnet, dass

c) die mindestens zwei Abschlüsse bekannte vom Zweitor (2) unabhängige, endliche Restimpedanzen (3a, 3b) sind.

2. Verfahren nach Anspruch 1, dadurch gekennzeichnet, dass zum Ermitteln des Wellenwiderstandes (ZW) und der Ausbreitungskonstanten (g) aus zwei gemessenen Eingangsimpedanzen (ZE1, ZE2) zwei Beziehungen von der Art

$$ZW = \sqrt{\frac{ZA1 \cdot ZE1 \cdot (ZA2 - ZE2) - ZA2 \cdot ZE2 \cdot (ZA1 - ZE1)}{(ZA2 - ZE2) - (ZA1 - ZE1)}}$$

$$g = \frac{1}{2 \cdot L} \ln \left[ \frac{(ZW + ZE1) \cdot (ZW - ZA1)}{(ZW - ZE1) \cdot (ZW + ZA1)} \right]$$

eingesetzt werden, wobei
ZA1 = effektive Restimpedanz für erste Eingangsimpedanz ZE1
ZA2 = effektive Restimpedanz für zweite Eingangsimpedanz ZE2
L = Länge des Zweitors
ln = natürlicher Logarithmus.

3. Verfahren nach Anspruch 2, dadurch gekennzeichnet, dass

a) bei mindestens drei verschiedenen gegebenen Abschlüssen mindestens drei Eingangsimpedanzen (ZE1, ZE2, ZE3) gemessen werden,

b) aus je zwei Eingangsimpedanzen jeweils ein vorläufiger Wellenwiderstand (ZW1, ZW2, ZW3) resp. eine vorläufige Ausbreitungskonstante (g1, g2, g3) ermittelt werden,

c) und ein endgültiger Wellenwiderstand (ZW) resp. endgültige Ausbreitungskonstante (g) durch eine Mittelung der vorläufigen Wellenwiderstände (ZW1, ZW2, ZW3) resp. vorläufigen Ausbreitungskonstanten (g1, g2, g3) erhalten werden.

4. Verfahren nach Anspruch 1, dadurch gekennzeichnet, dass zusätzlich die effektiven Restimpedanzen (ZA1, ZA2) für sich gemessen werden.

5. Verfahren nach Anspruch 4, dadurch gekennzeichnet, dass das Zweitor (2) ausschliesslich eine Leitung ist, und dass die effektiven Restimpedanzen (ZA1, ZA2) Anschlussstecker und ein kurzes Stück der Leitung umfassen.

6. Verfahren nach Anspruch 5, dadurch gekennzeichnet, dass

a) eine kurze Leitung (17) mit gegebenen Anschlusssteckern an ein Reflexionsmessgerät (1) angeschlossen wird, dass

b) nacheinander mindestens zwei Restimpedanzen (3a, 3b) an die kurze Leitung (17) angeschlossen werden, wobei jeweils eine effektive Restimpedanz (ZA1, ZA2) gemessen wird, dass

c) die kurze Leitung (17) durch eine lange Leitung (18) mit den selben Anschlusssteckern ersetzt wird und für die mindestens zwei Restimpedanzen (3a, 3b) jeweils eine Eingangsimpedanz (ZE1, ZE2) gemessen wird.

7. Verfahren nach Anspruch 4, dadurch gekennzeichnet, dass das Zweitor (2) ein Absorbermedium (19) ist und die Restimpedanz (3a, 3b) zwei parallele Leitungsdrähte (20) umfassen.

8. Verfahren nach Anspruch 7, dadurch gekennzeichnet, dass

a) zwei parallele Leitungsdrähte (20) mit gegebenen Anschlussleckern an ein Reflexionsmessgerät (1) angeschlossen werden, dass

b) nacheinander mindestens zwei Restimpedanzen (3a, 3b) an die parallelen Leitungsdrähte (20) angeschlossen werden, wobei jeweils eine effektive Restimpedanz (ZA1, ZA2) gemessen wird, dass

c) die parallelen Leitungsdrähte (20) in ein Absorbermedium (19) gebracht werden und für die mindestens zwei Restimpedanzen (3a, 3b) jeweils eine Eingangsimpedanz (ZE1, ZE2) gemessen wird.

Fig.1

Fig.2a

Fig.3a

Fig.2b

Fig.3b

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | NEWS FROM ROHDE & SCHWARZ, Band 118, Sommer 1987, Seite 21; T. REICHEL: "Transmission loss - determined by reflection measurement" * Insgesamt * --- | 1 | G 01 R 27/32 |
| A | DE-A-2 417 941 (SEL) * Anspruch * ----- | 1 | |

| | | |
|---|---|---|
| | | RECHERCHIERTE SACHGEBIETE (Int. Cl.4) |
| | | G 01 R |

Der vorliegende Recherchenbericht wurde für alle Patentansprüche erstellt

| Recherchenort | Abschlußdatum der Recherche | Prüfer |
|---|---|---|
| DEN HAAG | 20-03-1989 | HARRISON R.J. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
........................................................................
& : Mitglied der gleichen Patentfamilie, übereinstimmendes Dokument

EPO FORM 1503 03.82 (P0403)